# EUROPEAN PATENT APPLICATION

(11) **EP 4 307 383 A1**
(43) Date of publication of application: **17.01.2024**
(21) Application number: 22744635.8
(22) Date of filing: 09.06.2022
(51) Int. Cl.: H01L 29/06, H01L 29/10

(54) **SEMICONDUCTOR STRUCTURE**

(30) Priority: 30.05.2022 CN 202210599310
(71) Applicant: Changxin Memory Technologies, Inc., Hefei, Anhui 230601 (CN)
(72) Inventor: XIAO, Jianfeng, Hefei, Anhui 230601 (CN); TANG, Yi, Hefei, Anhui 230601 (CN)
(74) Representative: Lavoix
(86) International application number: PCT/CN2022/097891
(87) International publication number: WO 2023/231065

(57) **Abstract**

Embodiments of the present application provide a semiconductor structure. The semiconductor structure includes: a substrate and an active pillar located above the substrate. The active pillar extends in a first direction. The first direction is parallel to a plane where the substrate is located. The active pillar includes a body area extending in the first direction and a peripheral area surrounding the body area. The peripheral area includes a channel area. A type of doped ions of the channel area is the same as a type of doped ions of the body area, and a doping concentration of the channel area is greater than a doping concentration of the body area.

## Description

### CROSS-REFERENCE TO RELATED APPLICATION

This application is filed based upon and claims priority to Chinese Patent Application No. 202210599310.4, filed on May 30, 2022 and entitled "SEMICONDUCTOR STRUCTURE", the contents of which are hereby incorporated by reference in its entirety.

### TECHNICAL FIELD

The present application relates to the technical field of semiconductors, and more particularly, to a semiconductor structure.

### BACKGROUND

A semiconductor structure, such as a Three-dimensional Dynamic Random Access Memory, 3D DRAM, typically includes multiple transistors stacked onto one another on a substrate.

However, since the transistors are suspended on the substrate, charges tend to accumulate in channel areas of the transistors to generate a floating body effect, which in turn generates a warping effect, a parasitic bipolar transistor effect, a threshold voltage shift, etc., thereby affecting the performance of the semiconductor structure.

### SUMMARY

Embodiments of the present application provide a semiconductor structure. The semiconductor structure includes a substrate and at least one active pillar located above the substrate.

The active pillar extends in a first direction. The first direction is parallel to a plane where the substrate is located. The active pillar includes a body area extending in the first direction and a peripheral area surrounding the body area. The peripheral area includes a channel area. A type of doped ions of the channel area is the same as a type of doped ions of the body area, and a doping concentration of the channel area is greater than a doping concentration of the body area.

In some embodiments, the body area includes an inner layer extending in the first direction and an outer layer surrounding the inner layer, and a doping concentration of the inner layer is greater than a doping concentration of the outer layer.

In some embodiments, the doping concentration of the body area is gradually reduced from a center to a periphery in a radial direction of the active pillar.

In some embodiments, the peripheral area further includes a first doped area and a second doped area, the first doped area, the channel area and the second doped area are successively arranged in the first direction, the body area further comprises an extension area not surrounded by the peripheral area, and the extension area is adjacent to the first doped area.

In some embodiments, the semiconductor structure further includes: a conductive structure extending in a second direction and electrically connected to the extension area. The second direction intersects with the first direction and is parallel to the plane where the substrate is located.

In some embodiments, the semiconductor structure further includes: a conductive structure extending in a third direction and electrically connected to the extension area. The third direction is a direction perpendicular to the plane where the substrate is located.

In some embodiments, the semiconductor structure includes multiple active pillars arranged in multiple active pillar rows and multiple active pillar columns, the multiple active pillar rows extend in a second direction, the second direction intersects with the first direction and is parallel to the plane where the substrate is located, the multiple active pillar columns extend in a third direction, and the third direction is a direction perpendicular to the plane where the substrate is located.

In some embodiments, the semiconductor structure further includes: a conductive structure located on the substrate. The conductive structure has a plate shape, and the conductive structure is electrically connected to extension areas in the multiple active pillar rows.

In some embodiments, the conductive structure is grounded.

In some embodiments, the semiconductor structure further includes: multiple word lines and multiple bit lines. Each of the multiple word lines extends in the third direction, and the multiple word lines are arranged in the second direction. Each of the multiple word lines corresponds to a respective one of the multiple active pillar columns. Each of the multiple word lines covers multiple channel areas in the respective one of the multiple active pillar columns. Each of the multiple bit lines extends in the second direction. The multiple bit lines are arranged in the third direction. Each of the multiple bit lines corresponds to a respective one of the multiple active pillar rows. Each of the multiple bit lines is electrically connected to multiple first doped areas in the respective one of the multiple active pillar rows.

In some embodiments, the semiconductor structure further includes: multiple word lines and multiple bit lines. Each of the multiple word lines extends in the second direction, and the multiple word lines are arranged in the third direction. Each of the multiple word lines corresponds to a respective one of the multiple active pillar rows. Each of the multiple word lines covers multiple channel areas in the respective one of the multiple active pillar rows. Each of the multiple bit lines extends in the third direction, and the multiple bit lines are arranged in the second direction. Each of the multiple bit lines is electrically connected to multiple first doped areas in the respective one of the multiple active pillar columns.

In some embodiments, each of the multiple word lines surrounds corresponding channel area.

In some embodiments, each of the multiple word lines covers a side wall of the corresponding channel area.

In some embodiments, each of the multiple word lines includes a first sub-layer and a second sub-layer opposite to each other, and the first sub-layer covers one of two opposite side walls of corresponding channel area and the second sub-layer covers the other one of the two opposite side walls of the corresponding channel area.

In some embodiments, each of the multiple bit lines surrounds corresponding first doped area.

In some embodiments, each of the multiple bit lines includes multiple sub-portions, and the multiple sub-portions and the multiple first doped areas in the respective one of the active pillar columns are alternately stacked onto one another in the third direction.

Embodiments of the present application provide a semiconductor structure including a substrate and an active pillar located above the substrate. The active pillar extends in a first direction. The first direction is parallel to a plane where the substrate is located. The active pillar includes a body area extending in the first direction and a peripheral area surrounding the body area. The peripheral area includes a channel area. A type of doped ions of the channel area is the same as a type of doped ions of the body area, and a doping concentration of the channel area is greater than a doping concentration of the body area. An active pillar provided by an embodiment of the present application includes a body area and a peripheral area surrounding the body area, and a doping concentration of the body area is less than a doping concentration of a channel area. Thus, charge accumulation in the body area can be reduced, and a floating body effect can be mitigated. Furthermore, when excess charges exist in the channel area, the charges can be discharged via the body area. That is, the body area provides a path for the release of excess charges, thereby mitigating or eliminating the floating body effect and improving the performance of the semiconductor structure.

The details of one or more embodiments of the present application are set forth in the accompanying drawings and the description below. Other features and advantages of the present application will be apparent from the description, the drawings, and the claims.

### BRIEF DESCRIPTION OF THE DRAWINGS

In order to more clearly illustrate the technical solutions in embodiments of the present application, the accompanying drawings needing to be used in the embodiments will be briefly introduced below. It is apparent that the drawings in the following description are merely some embodiments of the present application and those ordinarily skilled in the art may also obtain other drawings according to these drawings without involving any inventive effort.
FIG. 1 is a perspective view of a semiconductor structure provided by an embodiment of the present application.
FIG. 2a is a perspective view of an active pillar provided by an embodiment of the present application, FIG. 2b is a schematic cross-sectional view taken along line A-A' of FIG. 2a, and FIG. 2c is a schematic cross-sectional view taken along line B-B' of FIG. 2a.
FIG. 3 to FIG. 8 are other examples of a perspective view of a semiconductor structure provided by an embodiment of the present application.

### DETAILED DESCRIPTION

Exemplary implementations of the present application will be described in more detail below with reference to the accompanying drawings. While the drawings show exemplary implementations of the present application, it should be understood that the present application may be embodied in various forms and should not be limited by specific implementations set forth herein. Rather, these implementations are provided so that the present application will be thoroughly understood, and the scope of the present application will be fully conveyed to those skilled in the art.

In the following descriptions, a lot of specific details are given in order to provide the more thorough understanding of the present application. However, it is apparent to those skilled in the art that the present application may be implemented without one or more of these details. In other examples, in order to avoid confusion with the present application, some technical features well-known in the field are not described. Namely, all the features of the actual embodiments are not described here, and well-known functions and structures are not described in detail.

In the drawings, the dimensions of a layer, a region, and an element and their relative dimensions may be exaggerated for clarity. The same reference numeral represents the same element throughout the description.

It should be understood that while the element or the layer is referred to as being "on", "adjacent to", "connected to" or "coupled to" other elements or layers, it may be directly on the other elements or layers, adjacent to, connected or coupled to the other elements or layers, or an intermediate element or layer may be existent. In contrast, while the element is referred to as being "directly on", "directly adjacent to", "directly connected to" or "directly coupled to" other elements or layers, the intermediate element or layer is not existent. It should be understood that although terms first, second, third and the like may be used to describe various elements, components, regions, layers and/or sections, these elements, components, regions, layers and/or sections should not be limited by these terms. These terms are only used to distinguish one element, component, region, layer or section from another element, component, region, layer or section. Therefore, without departing from the teaching of the present application, a first element, component, region, layer or section discussed below may be represented as a second element, component, region, layer or section. While the second element, component, region, layer or section is discussed, it does not mean that the first element, component, region, layer or section is necessarily existent in the present application.

Spatial relation terms, such as "under", "below", "lower", "underneath", "above", "upper" and the like, may be used here for conveniently describing so that a relationship between one element or feature shown in the drawings and other elements or features is described. It should be understood that in addition to orientations shown in the drawings, the spatial relationship terms are intended to further include the different orientations of a device in use and operation. For example, if the device in the drawings is turned over, then the elements or the features described as "below" or "underneath" or "under" other elements may be oriented "on" the other elements or features. Therefore, the exemplary terms "below" and "under" may include two orientations of up and down. The device may be otherwise oriented (rotated by 90 degrees or other orientations) and the spatial descriptions used here are interpreted accordingly.

A purpose of the terms used here is only to describe the specific embodiments and not as limitation to the present application. While used here, singular forms of "a", "an" and "said/the" are also intended to include plural forms, unless the context clearly indicates another mode. It should also be understood that terms "composition" and/or "including", while used in the description, determine the existence of the described features, integers, steps, operations, elements and/or components, but do not exclude the existence or addition of one or more other features, integers, steps, operations, elements, components, and/or groups. As used herein, a term "and/or" includes any and all combinations of related items listed.

A semiconductor structure, such as a Three-dimensional Dynamic Random Access Memory, 3D DRAM, in particular a 3D DRAM including a Multilayer Horizontal Cell, MHC, typically includes multiple transistors stacked onto one another on a substrate. The transistor typically includes a channel area at a middle region of the transistor and source/drain doped areas at both ends of the transistor. The type of doped ions of the channel area is different from the type of doped ions of the source/drain doped areas.

However, since the transistor is suspended on the substrate, charges tend to accumulate in the channel area of the transistor, and since the type of doped ions of the channel area is different from the type of doped ions of the source/drain doped areas, the charges accumulated in the channel area cannot be discharged, so as to generate a floating body effect, which in turn generates a warping effect, a parasitic bipolar transistor effect, a threshold voltage shift, etc., thereby affecting the performance of the semiconductor structure.

Based on this, the following technical solutions of the embodiments of the present application are provided. Specific implementations of the present application will be described below in detail with reference to the accompanying drawings. When describing the embodiments of the present application in detail, schematic diagrams are not necessarily to be partially enlarged for convenience of description, and the schematic diagrams are only examples and should not limit the scope of protection of the present application herein.

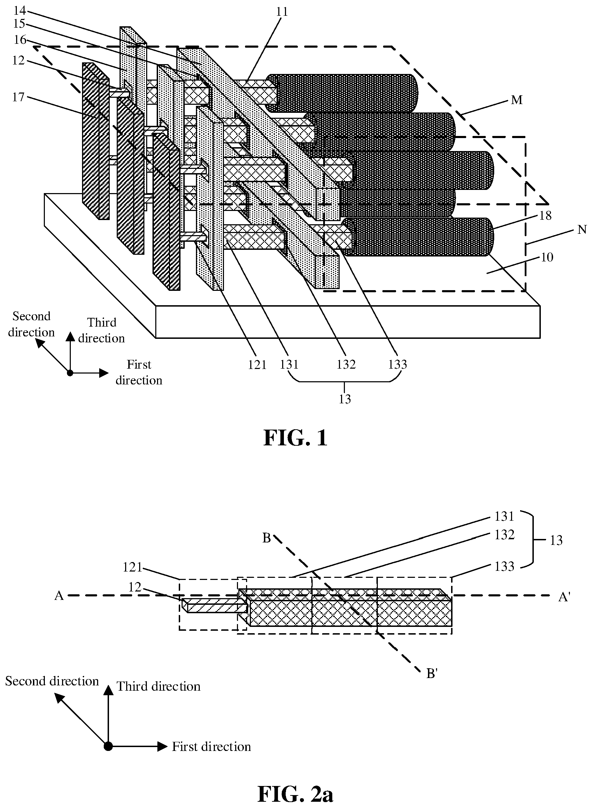

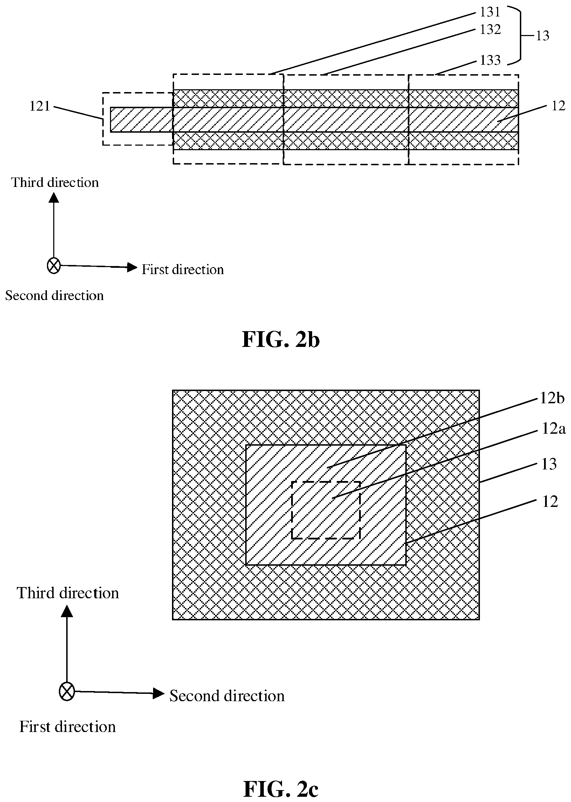

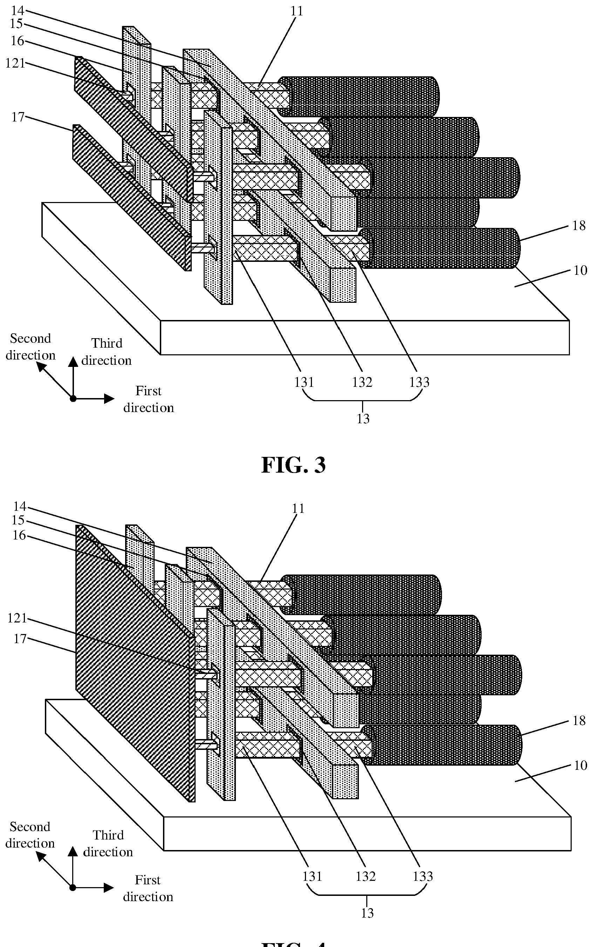

FIG. 1 is a perspective view of a semiconductor structure provided by an embodiment of the present application. FIG. 2a is a perspective view of an active pillar provided by an embodiment of the present application. FIG. 2b is a schematic cross-sectional view taken along line A-A' of FIG. 2a. FIG. 2c is a schematic cross-sectional view taken along line B-B' of FIG. 2a. FIG. 3 to FIG. 8 are other examples of a perspective view of a semiconductor structure provided by an embodiment of the present application. The semiconductor structure provided by an embodiment of the present application is further described below in conjunction with FIG. 1 to FIG. 8.

As shown in FIG. 1, the semiconductor structure includes a substrate 10 and an active pillar 11 located on the substrate 10. The active pillar 11 extends in a first direction. The first direction is parallel to a plane where the substrate 10 is located. As shown in FIG. 2a to FIG. 2b, the active pillar 11 includes a body area 12 extending in the first direction and a peripheral area 13 surrounding the body area 12. The peripheral area 13 includes a channel area 132. The type of the doped ions of the channel area 132 is the same as the type of the doped ions of the body area 12, and a doping concentration of the channel area 132 is greater than a doping concentration of the body area 12.

In an actual operation, the semiconductor structure provided by the embodiment of the present application may be, but is not limited thereto, a 3D DRAM, and the semiconductor device may also be any semiconductor device with a suspension transistor. The substrate may be a semiconductor substrate, and may include at least one elemental semiconductor material (for example, a silicon (Si) substrate and a germanium (Ge) substrate), at least one III-V compound semiconductor material, at least one II-VI compound semiconductor material, at least one organic semiconductor material, or other semiconductor materials known in the art. In a specific embodiment, the substrate is a silicon substrate, which may be doped or undoped.

An active pillar provided by an embodiment of the present application includes a body area and a peripheral area surrounding the body area, and a doping concentration of the body area is less than a doping concentration of a channel area. Thus, charge accumulation in the body area can be reduced, and a floating body effect can be mitigated. Furthermore, when excess charges exist in the channel area, the charges can be discharged via the body area. That is, the body area provides a path for the release of excess charges, thereby mitigating or eliminating the floating body effect and improving the performance of the semiconductor structure.

Here, when the ratio of the doping concentration of the channel area 132 to the doping concentration of the body area 12 is too low, the charge accumulation in the body area 12 is still relatively high and the mitigation function on the floating body effect is not significant, and when the ratio of the doping concentration of the channel area 132 to the doping concentration of the body area 12 is too high, the effect of discharging excess charges from the body area 12 is not good. Therefore, in some embodiments, the ratio of the doping concentration of the channel area 132 to the doping concentration of the body area 12 is greater than or equal to 10:1, specifically, for example, 13:1, 15:1, 19:1, 22:1, etc. Further, in other embodiments, the ratio of the doping concentration of the channel area 132 to the doping concentration of the body area 12 is less than or equal to 25:1.

As shown in FIG. 2c, in an embodiment, the body area 12 includes an inner layer 12a extending in the first direction and an outer layer 12b surrounding the inner layer 12a. A doping concentration of the inner layer 12a is greater than a doping concentration of the outer layer 12b. Thus, on the one hand, the outer layer 12b has a relatively low doping concentration and can reduce the amount of charges accumulated in the channel area 132, thereby mitigating the floating body effect, and on the other hand, the inner layer 12a has a relatively high doping concentration and can effectively improve the effect of discharging the accumulated charges in the channel area 132. In a specific embodiment, the ratio of the doping concentration of the inner layer 12a to the doping concentration of the outer layer 12b ranges from 5 to 10, specifically, for example, 6, 8, 9, etc. In some embodiments, the ratio of the radially extending length of the inner layer 12a to the radially extending length of the body area 12 is less than 0.5. Thus, the outer layer 12b with a low doping concentration has a sufficient thickness to ensure that accumulated charges in the channel area 132 can be discharged in time.

In another embodiment, the doping concentration of the body area 12 is gradually reduced from a center to a periphery in a radial direction of the active pillar 11. In an actual operation, preferably, the manner of gradually reducing is gradually reducing exponentially. Thus, on the one hand, a portion of the body area with a relatively low concentration can reduce the amount of charges accumulated in the body area 12, thereby mitigating the floating body effect, and on the other hand, a region in the body area 12 with a relatively high doping concentration can effectively improve the effect of discharging the accumulated charges in the channel area 132.

In some other implementations, the body area 12 includes a first layer and a second layer stacked onto one another successively and alternately in the radial direction of the active pillar 11, and the first layer and the second layer have different doping concentrations (not shown). It should be understood that two first layers and two second layers are at least included herein, and each of the doping concentration of the first layer and the doping concentration of the second layer is less than the doping concentration of the channel area 132. In some specific implementations, the ratio of the doping concentration of the first layer to the doping concentration of the second layer ranges from 2 to 5, for example, 2.5, 3, 4.5, etc. Thus, by arranging the layer with a high and the layer with a low doping concentration alternately, the amount of charges accumulated in the body area 12 can be further reduced, thereby better mitigating the floating body effect.

In an embodiment, as shown in FIG. 1 and FIG. 2a to FIG. 2c, the peripheral area 13 further includes a first doped area 131 and a second doped area 133. The first doped area 131, the channel area 132 and the second doped area 133 are arranged successively in the first direction. The body area 12 further includes an extension area 121 not surrounded by the peripheral area 13, and the extension area 121 is adjacent to the first doped area 131.

In some implementations, the material of the body area 12 is the same as the material of the peripheral area 13, and the material of the body area 12 and the material of the peripheral area 13 may be selected from one or more of silicon, indium oxide, tin oxide, indium zinc oxide, tin zinc oxide, aluminum zinc oxide, indium gallium oxide, indium gallium zinc oxide, indium aluminum zinc oxide, indium tin zinc oxide, tin gallium zinc oxide, aluminum gallium zinc oxide, and tin aluminum zinc oxide, for example silicon. In other implementations, the material of the body area 12 is different from the material of the peripheral area 13. For example, the material of the body area 12 may be selected from one or more of silicon or germanium and the like, and the material of the peripheral area 13 may be selected from one or more of indium oxide, tin oxide, indium zinc oxide, tin zinc oxide, aluminum zinc oxide, indium gallium oxide, indium gallium zinc oxide, indium aluminum zinc oxide, indium tin zinc oxide, tin gallium zinc oxide, aluminum gallium zinc oxide, and tin aluminum zinc oxide. Furthermore, the material of the extension area 121 may be the same as or different from the material of the portion of the body area 12 surrounded by the peripheral area 13. In some specific implementations, the doping concentration of the extension area 121 is different from the doping concentration of the body area 12. For example, an average doping concentration of the extension area 121 is greater than an average doping concentration of the body area 12, thereby facilitating the discharge efficiency of the accumulated charges in the body area 12.

In an embodiment, as shown in FIG. 2a and FIG. 2b, the radial dimension of the extension area 121 is smaller than the radial dimension of the active pillar 11, or a projection of the extension area 121 in the first direction falls into a projection of the active pillar 11 in the first direction, and the extension area 121 is not in contact with the first doped area 131.

In an actual preparation process, the above active pillar 11 may be formed by the following manners. First, an initial active pillar 11 is exposed to a gas-phase doping environment to globally dope the active pillar 11 with a first type of doped ions. Then, a first mask layer wrapping the active pillar 11 is formed, the first mask layer is etched to expose an end portion of the active pillar, and the end portion is etched so that the end portion forms an extension area with a radial dimension smaller than the radial dimension of the active pillar 11. Next, the first mask layer is removed, a second mask layer wrapping the active pillar 11 is formed, the second mask layer is etched to expose a region of the active pillar 11 where the channel area is to be formed, the region where the channel area is to be formed is exposed to the gas-phase doping environment, and a channel area 132 with a higher doping concentration is formed on the active pillar 11 by controlling doping parameters. Next, the second mask layer is removed to form a third mask layer wrapping the active pillar 11, the third mask layer is etched to expose a region where the first doped area 131 and the second doped area 133 are to be formed, the region where the first doped area 131 and the second doped area 133 are to be formed is exposed to the gas-phase doping environment, and the first doped area 131 and the second doped area 133 with a second type of doped ions are formed by controlling the doping parameters. The first type of doped ions may be P-type doped ions and the second type of doped ions may be N-type doped ions, or the first type of doped ions may be N-type doped ions and the second type of doped ions may be P-type doped ions. The body area having regions with different doping concentrations mentioned in the foregoing may be formed by multiple doping processes and will not be described in detail herein.

Without being limited thereto, in another embodiment, the extension area 121 has the same radial dimension as the active pillar 11, or the projection of the extension area 121 in the first direction coincides with the projection of the active pillar in the first direction. Furthermore, an end of the extension area 121 near the first doped area 131 may also be in contact with the first doped area 131. The extension area 121 and the active pillar 11 have the same radial dimension, thereby allowing no etching of the extension area 121 when preparing the active pillar 11 compared with a solution that the radial dimension of the extension area 121 is smaller, which simplifies the process and reduces the cost.

In some implementations, the number of active pillars 11 may be 1. In other embodiments, as shown in FIG. 1, there are multiple active pillars 11 arranged in an array. Specifically, as shown in FIG. 1, there are multiple active pillars 11, and the multiple active pillars 11 are arranged in multiple active pillar rows M and multiple active pillar columns N. The active pillar rows M extend in a second direction, and the second direction intersects with the first direction and is parallel to the plane where the substrate 10 is located. The active pillar columns N extend in a third direction, and the third direction is a direction perpendicular to the plane where the substrate 10 is located. In some embodiments, the first direction and the second direction are perpendicular to each other. Without being limited thereto, the first direction may be oblique to the second direction.

As shown in FIG. 1, in some embodiments, the semiconductor structure further includes a conductive structure 17 extending in the third direction and electrically connected to the extension area 121. The third direction is a direction perpendicular to the plane where the substrate 10 is located. Here, the conductive structure 17 may be, for example, a linear structure. In some implementations, there may be multiple conductive structures 17 parallel to each other. The multiple conductive structures 17 are arranged in the second direction. Each conductive structure 17 extends to the substrate 10 in the third direction perpendicular to the plane where the substrate 10 is located, and each of the conductive structures 17 corresponds to a respective active pillar column N of the multiple active pillar columns N. Each conductive structure 17 is electrically connected to the extension areas 121 of the multiple active pillars 11 in the respective active pillar column N.

As shown in FIG. 3, in another embodiment, the conductive structure 17 extends in the second direction and is electrically connected to the extension area 121. The second direction intersects with the first direction and is parallel to the plane where the substrate 10 is located. Here, the conductive structure 17 may be, for example, a linear structure. In some implementations, there may be multiple conductive structures 17. The multiple conductive structures 17 are arranged in the third direction. Each of the conductive structures 17 corresponds to a respective active pillar row M of the multiple active pillar rows M. Each conductive structure 17 is electrically connected to the extension areas 121 of the multiple active pillars 11 in the respective active pillar row M.

Without being limited thereto, as shown in FIG. 4, in other embodiments, the conductive structure 17 has a plate shape, and the conductive structure 17 is electrically connected to the extension areas 121 in the multiple active pillar rows M. Specifically, the conductive structure 17 extends to the substrate 10 in the third direction and is electrically connected to the extension areas 121 of each of the active pillars 11 in each of the active pillar rows M.

Here, the conductive structure 17 may be grounded. Thus, when excess charges exist in the channel area 132, charges may be discharged to the body area 12 and released via the conductive structure 17 grounded, thereby further mitigating or eliminating the floating body effect.

The plate-shaped conductive structure 17 can discharge all the active pillars 11 as a whole, and has a simple structure and a high discharge efficiency. The linear conductive structure 17 can discharge floating body charges for one row of active pillars 11 or one column of active pillars 11 compared to the plate-shaped conductive structure 17, which allows a targeted selective discharge of some rows or columns requiring floating body charge discharge according to the actual operating conditions of the active pillars 11, thereby minimizing the additional influence of the discharge on the device operation while mitigating the floating body effect.

In an actual operation, the material of the conductive structure 17 includes at least one of conductive materials such as polysilicon. For example, the material of the conductive structure 17 includes one or more of polysilicon, tungsten (W), copper (Cu), titanium (Ti), tantalum (Ta), titanium nitride (TiN), tantalum nitride (TaN), metal silicide, and a metal alloy. The conductive structure 17 may be formed through a process such as Chemical Vapor Deposition, CVD, Plasma Enhanced CVD, PECVD, Physical Vapor Deposition, PVD, Atomic Layer Deposition, ALD, electroplating, chemical plating, and sputtering.

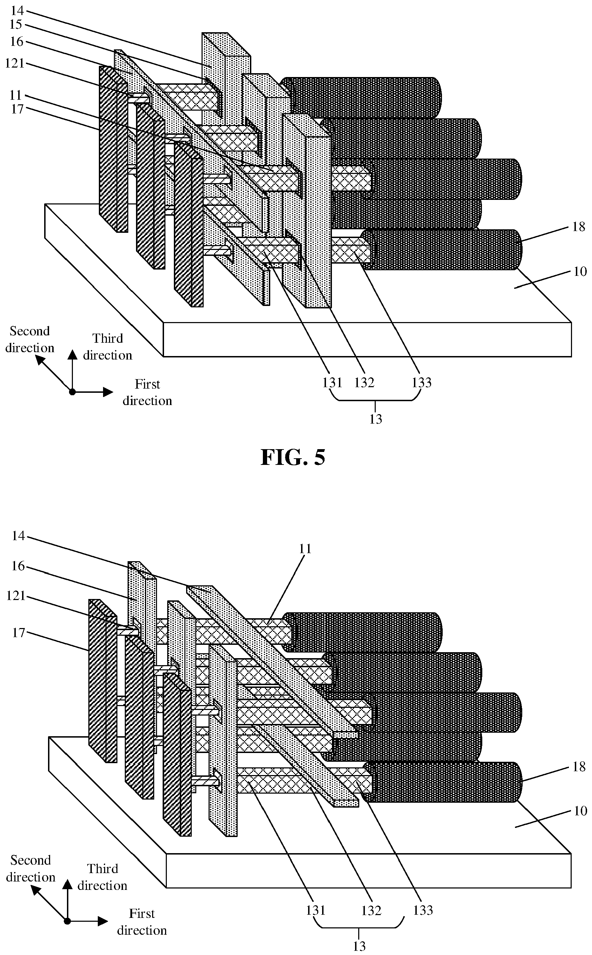

As shown in FIG. 5, in an embodiment, the semiconductor structure further includes multiple word lines 14 and multiple bit lines 16. Each of the word lines 14 extends in the third direction, and the multiple word lines 14 are arranged in the second direction. Each of the word lines 14 corresponds to a respective active pillar column N of the active pillar columns N. Each of the word lines 14 covers multiple channel areas 132 in the respective active pillar column N. Each of the bit lines 16 extends in the second direction. The multiple bit lines 16 are arranged in the third direction. Each of the bit lines 16 is connected to multiple first doped areas 131 in a respective active pillar row M of the active pillar rows M corresponding to each of the bit lines 16.

Without being limited thereto, the word lines 14 may also extend in the second direction and the bit lines 16 may also extend in the third direction. Specifically, the semiconductor structure further includes multiple word lines 14 and multiple bit lines 16. Each of the word lines 14 extends in the second direction, and the multiple word lines 14 are arranged in the third direction. Each of the word lines 14 corresponds to a respective active pillar row M of the active pillar rows M. Each of the word lines 14 covers multiple channel areas 132 in the respective active pillar row M. Each of the bit lines 16 extends in the third direction, and the multiple bit lines 16 are arranged in the second direction. Each of the bit lines 16 is electrically connected to multiple first doped areas 131 in a respective active pillar column N of the active pillar columns N corresponding to each of the bit lines 16.

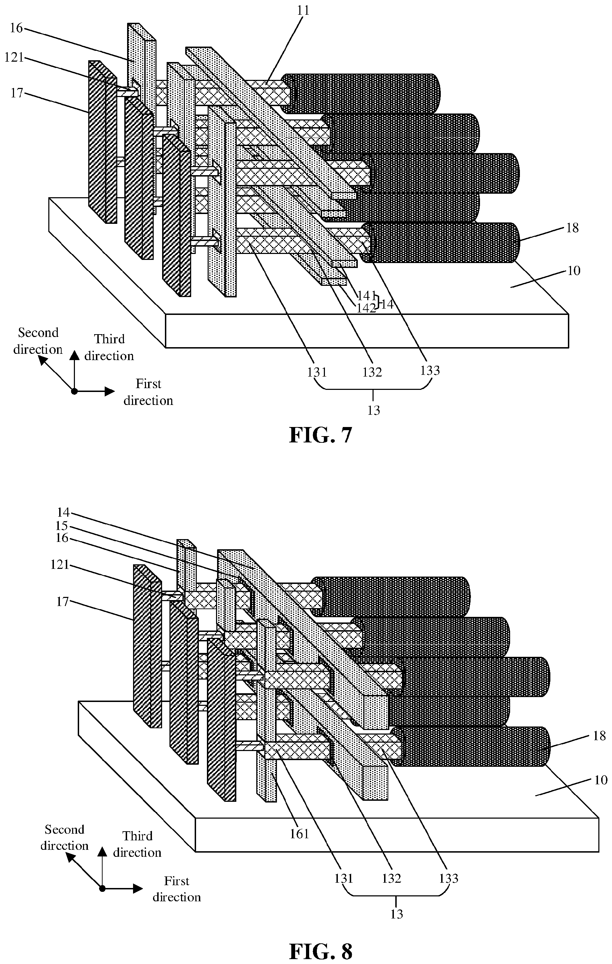

As shown in FIG. 1 or FIG. 5, in an embodiment, the word line 14 surrounds a corresponding channel area 132, and the word line 14 extends in the second direction or the third direction. Alternatively, as shown in FIG. 6, in other embodiments, the word line 14 covers a side wall of the corresponding channel area 132, and the word line 14 extends in the second direction or the third direction. Still alternatively, as shown in FIG. 7, in other embodiments, the word line 14 includes a first sub-layer 141 and a second sub-layer 142 opposite to each other. The first sub-layer 141 covers one of two opposite side walls of the corresponding channel area 132, and the second sub-layer 142 covers the other one of the two opposite side walls of the corresponding channel area 132. The first sub-layer 141 and the second sub-layer 142 extend in the second direction or the third direction. It will be appreciated that the first sub-layer 141 is electrically connected to the second sub-layer 142.

As shown in FIG. 5 or FIG. 6, in some embodiments, the bit line 16 surrounds a corresponding first doped area 131, and the bit line 16 extends in the second direction or the third direction. In other embodiments, the bit line 16 may also cover a side wall of the corresponding first doped area 131. Without being limited thereto, as shown in FIG. 8, in other embodiments, the bit line 16 includes multiple sub-portions 161. The multiple sub-portions 161 and the first doped areas 131 in a respective one of the active pillar columns N are alternately stacked onto one another in the third direction. Alternatively, the multiple sub-portions 161 and the first doped areas 131 in a respective one of the active pillar rows M may be alternately arranged in the second direction.

The material of the word line 14 and the material of the bit line 16 may include one or more of tungsten (W), copper (Cu), titanium (Ti), tantalum (Ta), titanium nitride (TiN), tantalum nitride (TaN), metal silicide, and a metal alloy. The word line 14 and the bit line 16 may be formed through a process such as CVD, PECVD, PVD, ALD, electroplating, chemical plating, and sputtering.

In an embodiment, the semiconductor structure further includes a gate dielectric layer 15 sandwiched between the word line 14 and the channel area 132. The material of the gate dielectric layer 15 may be a high dielectric constant material, such as tantalum oxide, hafnium oxide, zirconium oxide, niobium oxide, titanium oxide, barium oxide, strontium oxide, yttrium oxide, lanthanum oxide, praseodymium oxide, or barium strontium titanate. The gate dielectric layer 15 may be formed through a process such as CVD, PECVD, PVD, ALD, electroplating, chemical plating, and sputtering. Without being limited thereto, the material of the active pillar 11 may be silicon, the material of the gate dielectric layer 15 may be silicon oxide, and the gate dielectric layer 15 may be formed by a thermal oxidation process.

In some embodiments, the semiconductor material further includes multiple capacitor structures 18 for information storage. The capacitor structures 18 are electrically connected to the second doped areas 133 of the active pillars 11. Specifically, the capacitor structures 18 extend in the first direction, and the capacitor structures 18 are arranged in an array in the second direction and the third direction.

In an embodiment, the capacitor structure includes a lower electrode electrically connected to the second doped area, a dielectric layer covering the lower electrode, and a common upper electrode covering the dielectric layer and located between the multiple capacitor structures. In some embodiments, the lower electrode is cylindrical and extends in the first direction. Without being limited thereto, in other embodiments, the lower electrode has a tubular structure, and an opening of the tubular structure is oriented toward the first direction.

It can be seen that the active pillar 11 provided in the embodiment of the present application includes a body area 12 and a peripheral area 13 surrounding the body area 12, and the doping concentration of the body area 12 is less than the doping concentration of the channel area 132. Thus, by providing that the doping concentration of the body area 12 is less than the doping concentration of the channel area 132, charge accumulation in the body area 12 can be reduced, thereby mitigating the floating body effect. Further, when excess charges exist in the channel area 132, the charges can be discharged via the body area 12. That is, the body area 12 provides a path for the release of excess charges. Furthermore, the conductive structure 17 provided in the embodiment of the present application is grounded. When excess charges exist in the channel area 132, charges may be discharged to the body area 12 and released via the conductive structure 17 grounded, thereby mitigating or eliminating the floating body effect.

The above are only preferred embodiments of the present application, and are not used to limit the scope of protection of the present application. Any modifications, equivalent replacements and improvements and the like made within the spirit and principle of the present application shall be included within the scope of protection of the present application.

### INDUSTRIAL APPLICABILITY

An active pillar provided by an embodiment of the present application includes a body area and a peripheral area surrounding the body area, and a doping concentration of the body area is less than a doping concentration of a channel area. Thus, charge accumulation in the body area can be reduced, and a floating body effect can be mitigated. Furthermore, when excess charges exist in the channel area, the charges can be discharged via the body area. That is, the body area provides a path for the release of excess charges, thereby mitigating or eliminating the floating body effect and improving the performance of the semiconductor structure.

## Claims

1. A semiconductor structure, comprising:
a substrate and at least one active pillar located above the substrate, the active pillar extending in a first direction, and the first direction being parallel to a plane where the substrate is located,
wherein the active pillar comprises a body area extending in the first direction and a peripheral area surrounding the body area, and the peripheral area comprises a channel area, and
wherein a type of doped ions of the channel area is the same as a type of doped ions of the body area, and a doping concentration of the channel area is greater than a doping concentration of the body area.

2. The semiconductor structure according to claim 1, wherein the body area comprises an inner layer extending in the first direction and an outer layer surrounding the inner layer, and a doping concentration of the inner layer is greater than a doping concentration of the outer layer.

3. The semiconductor structure according to claim 2, wherein the doping concentration of the body area is gradually reduced from a center to a periphery in a radial direction of the active pillar.

4. The semiconductor structure according to claim 1, wherein the peripheral area further comprises a first doped area and a second doped area, and the first doped area, the channel area and the second doped area are successively arranged in the first direction, wherein the body area further comprises an extension area not surrounded by the peripheral area, and the extension area is adjacent to the first doped area.

5. The semiconductor structure according to claim 4, further comprising: a conductive structure extending in a second direction and electrically connected to the extension area, wherein the second direction intersects with the first direction and is parallel to the plane where the substrate is located.

6. The semiconductor structure according to claim 4, further comprising: a conductive structure extending in a third direction and electrically connected to the extension area, wherein the third direction is a direction perpendicular to the plane where the substrate is located.

7. The semiconductor structure according to claim 1, wherein the semiconductor structure comprises multiple active pillars arranged in multiple active pillar rows and multiple active pillar columns, the multiple active pillar rows extend in a second direction, the second direction intersects with the first direction and is parallel to the plane where the substrate is located, the multiple active pillar columns extend in a third direction, and the third direction is a direction perpendicular to the plane where the substrate is located.

8. The semiconductor structure according to claim 7, further comprising: a conductive structure located on the substrate, wherein the conductive structure has a plate shape, and the conductive structure is electrically connected to extension areas in the multiple active pillar rows.

9. The semiconductor structure according to any one of claims 5 to 6 or 8, wherein the conductive structure is grounded.

10. The semiconductor structure according to claim 7, further comprising: multiple word lines, wherein each of the multiple word lines extends in the third direction, the multiple word lines are arranged in the second direction, each of the multiple word lines corresponds to a respective one of the multiple active pillar columns, and each of the word lines covers multiple channel areas in the respective one of the multiple active pillar columns; and
multiple bit lines, wherein each of the multiple bit lines extends in the second direction, the multiple bit lines are arranged in the third direction, each of the multiple bit lines corresponds to a respective one of the multiple active pillar rows, and each of the bit lines is electrically connected to multiple first doped areas in the respective one of the multiple active pillar rows.

11. The semiconductor structure according to claim 7, further comprising: multiple word lines, each of the multiple word lines extends in the second direction, the multiple word lines are arranged in the third direction, each of the multiple word lines corresponds to a respective one of the multiple active pillar rows, and each of the multiple word lines covers multiple channel areas in the respective one of the multiple active pillar rows; and
multiple bit lines, wherein each of the multiple bit lines extends in the third direction, the multiple bit lines are arranged in the second direction, and each of the multiple bit lines is electrically connected to multiple first doped areas in the respective one of the multiple active pillar columns.

12. The semiconductor structure according to claim 10 or 11, wherein each of the multiple word lines surrounds corresponding channel area.

13. The semiconductor structure according to claim 10 or 11, wherein each of the multiple word lines comprises a first sub-layer and a second sub-layer opposite to each other, and the first sub-layer covers one of two opposite side walls of corresponding channel area and the second sub-layer covers the other one of the two opposite side walls of the corresponding channel area.

14. The semiconductor structure according to claim 10 or 11, wherein each of the multiple bit lines surrounds corresponding first doped area.

15. The semiconductor structure according to claim 11, wherein each of the multiple bit lines comprises multiple sub-portions, and the multiple sub-portions and the multiple first doped areas in the respective one of the active pillar columns are alternately stacked onto one another in the third direction.
